# FASCICULE DE BREVET EUROPEEN

(11) **EP 2 937 823 B1**
(45) Date de publication et mention de la délivrance du brevet: **02.09.2020**
(21) Numéro de dépôt: 15165086.8
(22) Date de dépôt: 24.04.2015
(51) Int. Cl.: H05K 1/18, G06K 19/077, H05K 3/30

(54) **PROCÉDÉ DE FABRICATION D'UNE STRUCTURE POUR CARTE À PUCE ET STRUCTURE DE CARTE À PUCE OBTENUE PAR CE PROCÉDÉ**
HERSTELLUNGSVERFAHREN EINER STRUKTUR FÜR CHIPKARTEN, UND MIT DIESEM VERFAHREN ERHALTENE STRUKTUR FÜR CHIPKARTE
METHOD FOR MANUFACTURING A STRUCTURE FOR SMART CARD AND SMART-CARD STRUCTURE OBTAINED BY SAID METHOD

(30) Priorité: 24.04.2014 FR 1453705
(43) Date de publication de la demande: 28.10.2015
(73) Titulaire: Linxens Holding, 78280 Guyancourt (FR)
(72) Inventeur: Mathieu, Christophe, 78200 MANTES LA JOLIE (FR); Proye, Cyril, 78200 MAGNANVILLE (FR)
(74) Mandataire: GIE Innovation Competence Group

(56) Documents cités:
- EP-A1- 1 442 424
- WO-A1-2013/027789
- FR-A1- 2 863 747
- FR-A1- 2 996 944
- US-A1- 2002 162 894

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données de la puce à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention permet de réaliser en particulier des cartes à puce à double interface. Les cartes à puce à double interface sont appelées « dual » si les modes « avec contact » et « sans contact » sont gérés par une seule puce ou « hybrides » si les modes « avec contact » et « sans contact » sont gérés par deux puces physiquement distinctes.

Les cartes à puce à double interface sont généralement constituées d'un support rigide en matière plastique de type PVC, PVC/ABS, PET ou polycarbonate constituant l'essentiel de la carte, dans lequel sont incorporés un module électronique et une antenne fabriqués séparément. Le module électronique comporte un circuit imprimé généralement flexible muni d'une puce électronique (circuit intégré) et des plages de contacts électriquement connectées à la puce et affleurant sur le module électronique, en surface du support, pour une connexion par contact électrique avec un dispositif lecteur de carte. Les cartes à puce à double interface comportent en outre au moins une antenne pour transmettre des données entre la puce et un système radiofréquence permettant la lecture/écriture des données sans contact.

Dans l'art antérieur, par exemple FR2 863 747, le module électronique comprenant les contacts et la puce, d'une part, et l'antenne éventuellement intégrée à un support (« inlay » selon la terminologie anglo-saxonne), d'autre part, sont généralement fabriqués séparément, puis l'antenne est connectée au module sur lequel est montée et connectée la puce. La connexion entre l'antenne et le module est réalisée selon des procédés industriels complexes qui impactent négativement la productivité, les rendements de fabrication et la fiabilité des cartes lors de leur utilisation.

Dans le document FR2 996 944, on réalise sur un même support, ou substrat, les contacts et l'antenne. Il ne reste alors plus qu'à connecter la puce à au moins certains des contacts et à l'antenne.

Selon l'invention, le substrat a des dimensions dans son plan principal telles que sa première face peut être en partie recouverte d'une couche comportant une découpe laissant apparaître totalement les contacts. Ce substrat, dont les dimensions dans son plan principal sont plus grandes que les dimensions de la cavité telles que définies par la norme ISO 7816, peut recevoir une antenne de plus grandes dimensions (pour un meilleur couplage avec un dispositif de lecture).

Cependant, la carte intégrant un support ou substrat commun à l'antenne et aux contacts doit satisfaire à des exigences esthétiques (pas ou peu de marques visibles sur les faces externes de la carte, compatibilité avec les lignes d'embossage pour un numéro de carte par exemple). Elle doit également garantir une connexion électrique fiable et robuste entre la puce, d'une part, et les contacts et l'antenne, d'autre part. Elle doit aussi satisfaire à des normes définissant son épaisseur, la position et la taille des contacts, les dimensions de l'antenne, etc.

Le procédé de fabrication de structures de carte à puce selon l'invention comprend alors la fourniture d'un substrat. Ce substrat peut être un substrat diélectrique en matériau composite (verre-époxy) ou en matériau plastique (PET, PEN, polyimide, etc.). Il peut également être constitué d'une simple et unique couche d'adhésif. Ce substrat diélectrique est généralement mince. Son épaisseur est par exemple de l'ordre de 20 à 200µm pour conserver une flexibilité compatible avec des procédés de fabrication de circuit imprimés en continu (« reel-to-reel » selon la terminologie anglo-saxonne). Son épaisseur est préférentiellement de l'ordre de 60 µm. Ce substrat se présente donc sous forme d'une feuille ayant une première et une deuxième faces principales essentiellement parallèles entre elles.

Sur la première face du substrat, aussi appelée « face contact » ou « face avant », on réalise des contacts pour une connexion électrique temporaire avec un dispositif à contacts de lecture de carte. Par exemple, les contacts de la carte sont réalisés à partir d'une feuille de matériau électriquement conducteur, tel que du cuivre.

Par exemple, une feuille de cuivre est collée sur un substrat de type stratifié cuivré (« copper clad » selon la terminologie anglo-saxonne) sur la face opposée à celle déjà cuivrée, à l'aide d'une couche d'adhésif, dont l'épaisseur est par exemple de l'ordre de 20 µm, pour réaliser un circuit imprimé double-face à trous métallisés.

Selon un autre exemple, une feuille de cuivre peut-être directement reportée, pour y être collée, sur un substrat de type stratifié cuivré, si ce substrat est lui-même constitué par un adhésif électriquement isolant (dont l'épaisseur est par exemple de 60 µm environ).

La feuille de matériau électriquement conducteur, solidaire du substrat est gravée pour définir des zones de contacts et d'éventuels autres éléments de circuiterie (tels que des amenées de courant pour métalliser ces zones). Selon une autre technique (« leadframe » selon la terminologie anglo-saxonne), les zones de contacts et les éventuels autres éléments de circuiterie sont découpés dans une feuille de matériau électriquement conducteur, tel que du cuivre allié, avant d'être reportés et colaminés sur le substrat.

Sur la première ou la deuxième face du substrat (aussi appelée « face arrière » ou « face bonding »), on réalise, une antenne pour un couplage électromagnétique avec un dispositif de lecture de cartes sans contact. La réalisation de l'antenne sur la première ou la deuxième face du substrat peut se faire par l'une des technologies déjà mentionnées (collage et/ou colamination d'une feuille de matériau électriquement conducteur sur une face du substrat puis gravure de l'antenne ou découpe de l'antenne dans une feuille de matériau électriquement conducteur puis collage et/ou colamination sur une face du substrat).

Si l'antenne et les contacts sont sur deux faces distinctes, ils peuvent être gravés simultanément.

Selon une variante, l'antenne et les contacts sont gravés au cours de deux étapes distinctes et successives. L'antenne peut être est réalisée sur le substrat avant les contacts ou inversement. Il suffit d'adapter l'ordre des étapes, décrites ci-dessus, mises en œuvre respectivement sur les première et deuxième faces.

Une fixation mécanique d'une puce électronique sur le substrat est réalisée par au moins une technique connue telle que le fixage de puce (die-attach selon la terminologie anglo-saxonne) et sa connexion électrique à au moins certains contacts et à l'antenne est réalisée par au moins une technique connue telle que la technologie de la puce retournée (« flip-chip » selon la technologie anglo-saxonne), la soudure de fils (« wire-bonding » selon la terminologie anglo-saxonne), etc. Un composant passif tel qu'un condensateur peut également être connecté à l'antenne.

Si l'antenne est réalisée sur la deuxième face, la puce pourra être directement connectée à l'antenne ou bien la connexion de la puce à l'antenne pourra se faire via des trous métallisés à travers le substrat ou via des fils traversant le substrat dans des trous non-métallisés et des contacts non-utilisés pour la transmission des données avec contact. Si l'antenne est réalisée sur la première face, la connexion de la puce à l'antenne pourra se faire via des trous métallisés ou via des fils traversant le substrat dans des trous non-métallisés.

Afin de protéger la puce, l'éventuel composant passif et leurs connexions à au moins certains des contacts et à l'antenne, ceux-ci sont encapsulés dans une résine (« globe top » ou « dam&fill » selon la terminologie anglo-saxonne, correspondant à une encapsulation UV ou thermique). La puce étant placée sur la deuxième face du substrat ou dans une découpe réalisée dans celle-ci, l'encapsulation est réalisée à partir de cette deuxième face du substrat et peut former une surépaisseur par rapport à cette face, sur une certaine zone que l'on nommera par la suite « zone d'encapsulation ».

Afin d'éviter ou de limiter les défauts esthétiques sur les surfaces de la carte finie, on fournit au moins une couche d'absorption que l'on vient placer sous la deuxième face, au moins sous l'antenne et autour de la zone d'encapsulation. Ainsi, on évite au moins l'apparition d'une image « fantôme » des spires de l'antenne sur les faces externes de la carte finie.

La couche d'absorption peut comporter une découpe au niveau de la zone d'encapsulation pour loger cette dernière, ou au contraire, s'étendre sous la zone d'encapsulation. Ces deux solutions sont possibles. On adapte l'épaisseur de la couche d'absorption en fonction du choix de l'une ou de l'autre de ces solutions.

La couche d'absorption peut s'étendre plus largement sur l'ensemble de la surface correspondant à la carte finie.

La couche d'absorption peut être réalisée par empilement de plusieurs couches. L'épaisseur de la ou des couche(s) d'absorption doit être suffisante pour absorber la surépaisseur formée par l'encapsulation de la puce. Par exemple, on choisit les épaisseurs de la ou des couche(s) d'absorption de manière à ce que leur épaisseur totale soit comprise entre 300 et 400 µm (avant lamination). Au moins l'une des couches d'absorption est par exemple en PVC à bas point Vicat (par exemple, son point Vicat est voisin de 75°C ou inférieur à cette valeur).

En outre, on fournit une couche d'impression au-dessus de la première face, avec une découpe réalisée dans toute l'épaisseur de cette couche d'impression de manière à laisser apparaître les contacts, et une couche d'impression au-dessous de la deuxième face. Ces couches d'impression comportent généralement les motifs, les couleurs, les inscriptions, etc. que l'on veut voir figurer sur les faces de la carte. Toutefois, dans de rares cas, on peut prévoir de laisser ces couches d'impression blanches.

Eventuellement, les couches d'impression sont protégées par un vernis appliqué directement sur la couche d'impression, ceci afin de réduire l'épaisseur totale de la carte.

Alternativement, on prévoit des couches supérieures et inférieures de finition et de protection de la carte (respectivement « recto overlay » et « verso overlay » selon la terminologie anglo-saxonne). La ou les couches supérieure et inférieure est (sont) par exemple en PVC.

En outre, on peut éventuellement placer une couche de compensation autour du substrat, sur la ou les couche(s) d'absorption, par exemple si le substrat ne couvre pas la totalité de la surface de la carte finie. L'épaisseur de cette couche de compensation est choisie de manière à être égale, ou sensiblement égale, à celle du substrat, avec une tolérance maximale de plus ou moins 10%. La couche de compensation est par exemple en PVC.

La totalité des épaisseurs de la ou des couche(s) d'absorption et de la couche de compensation est alors par exemple comprise entre 400 et 500 µm avant lamination.

L'ensemble de la structure comprenant au moins le substrat et la couche d'absorption (plus les éventuelles couches d'impression, de compensation, de finition, etc.) est laminé à chaud au cours d'une unique opération de lamination, en une première et une deuxième opérations de lamination réalisées l'une après l'autre, ou encore en plus d'opérations distinctes de lamination. Par exemple, le cycle de lamination comprend un cycle chaud et un cycle froid (sur une même presse de lamination ou bien sur deux presses séparées). Le cycle de lamination s'effectue avec un gradient de pression et de température, avec une température de lamination comprise entre 20 et 150°C. Pour le cycle chaud le gradient de pression est compris entre 5 et 100 N/cm². Pour le cycle froid le gradient de pression est compris entre 100 et 200 N/cm². Les températures et pressions du cycle de lamination sont adaptées pour ne pas faire fluer la matière des couches (PVC), pour ne pas détruire l'électronique de la puce et pour prévenir les défauts esthétiques sur les surfaces externes de la carte, comme par exemple l'image fantôme des spires de l'antenne ou bien les zones de matière ayant subies des retards de pression à la lamination (« flash » selon la terminologie anglo-saxonne).

Selon l'invention, il est aussi possible de réaliser une carte en deux groupes distincts d'opérations : un premier groupe consistant à réaliser une structure prélaminée, aussi appelée « prélam » selon la terminologie anglo-saxonne (qui peut être fabriquée et vendue avant d'être intégré dans un corps de carte), avec un substrat, des contacts, une antenne, une puce, éventuellement un composant passif, une résine d'encapsulation et une couche d'absorption (éventuellement multiple) et un deuxième groupe d'opérations pour finir la carte avec les couches d'impression et les éventuelles couches supérieure et inférieure de finition, colaminées toutes ensemble.

L'invention concerne également une structure pour carte à puce obtenue par ce procédé. La structure de carte à puce selon l'invention correspond donc à une structure comportant un substrat, des contacts, une antenne, une puce électronique encapsulée et au moins une couche d'absorption et éventuellement des couches supplémentaires de compensation et/ou d'impression et/ou de protection (couches supérieure et inférieure), jusqu'à éventuellement une structure constituant une carte à puce complète.

D'autres caractéristiques et avantages de l'invention apparaîtront à la lecture de la description détaillée et des dessins annexés sur lesquels :
- La figure 1 représente schématiquement en perspective une carte à puce destinée à recevoir une structure pour carte à puce selon l'invention ;
- La figure 2 représente schématiquement vu par sa face arrière (la face avant étant vue en transparence), un substrat avec des contacts et une antenne, ce substrat étant destiné à être inséré dans une carte telle que celle représentée sur la figure 1 ;
- La figure 3 représente schématiquement en coupe le substrat de la figure 2 ;
- La figure 4 représente schématiquement en coupe l'ensemble des couches d'une carte à puce telle que celle de la figure 1, avant lamination ;
- la figure 5 représente schématiquement en coupe l'ensemble des couches d'une variante de la carte à puce de la figure 4, avant lamination ;
- La figure 6 représente schématiquement en coupe l'ensemble des couches d'une variante des cartes à puce des figure 4 et 5, avant lamination ; et
- La figure 7 représente schématiquement en coupe l'ensemble des couches d'une variante des cartes à puce de la figure 4, 5 et 6 avec une structure intermédiaire correspondant à une première lamination (« prelam » selon la terminologie anglo-saxonne).

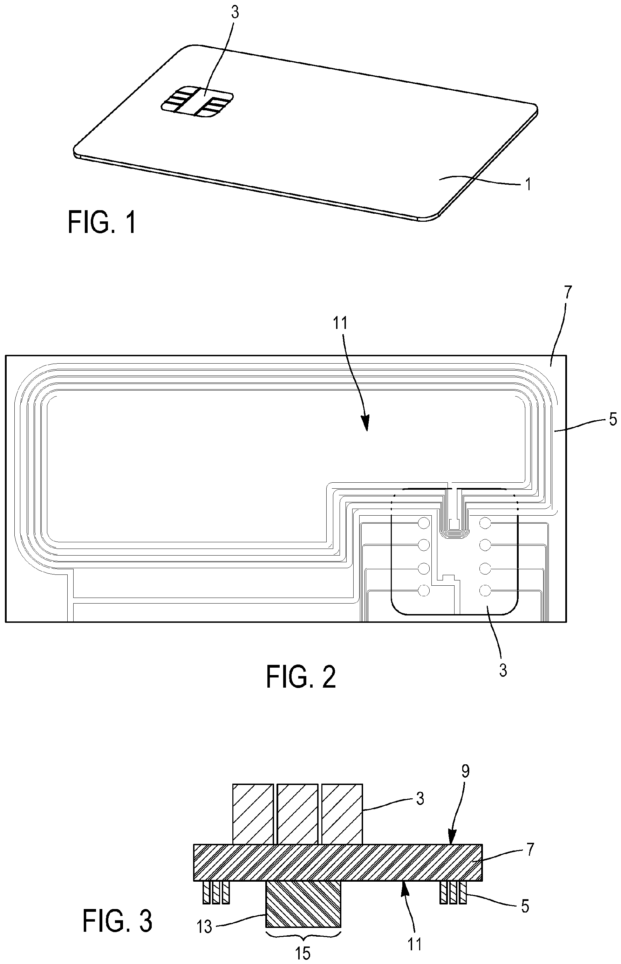

La carte à puce 1 représentée sur la figure 1 est à double-interface (« dual-interface »). Elle comporte des contacts 3 et une antenne 5 (non-visible sur la figure 1). L'antenne 5 est constituée d'une boucle conductrice qui peut comprendre une ou plusieurs spires.

Les contacts 3 et l'antenne 5 sont réalisés sur un substrat 7 (figures 2 et 3). Ce substrat 7 est par exemple constitué d'un circuit flexible muni de contacts 3, sur une première face 9 (c'est-à-dire la face avant ou face contact), et d'une antenne 5, sur une deuxième face 11 (c'est-à-dire la face arrière ou face « bonding »). Sur la figure 2, le substrat 7 est représenté avec sa deuxième face 11 sur le dessus. Le substrat 7 est par exemple réalisé grâce à un procédé tel que celui décrit dans la demande de brevet français déposée sous le numéro FR13 57749 (Numéro de publication FR3003723A1). Dans ce cas, le substrat 7 est constitué d'une couche d'adhésif électriquement isolant de 60µm d'épaisseur environ. La nature chimique de cet adhésif est par exemple un epoxy modifié par un thermoplastique (de type polyamide par exemple). Sa viscosité est adaptée pour qu'il puisse être étalé par enduction à température ambiante sur une couche électriquement conductrice ou un substrat amovible. Par exemple sa viscosité en phase solvant est de l'ordre de 80 mPa.s (plus généralement comprise entre 60 et 100 mPa.s). Il a par exemple une température de transition vitreuse Tg de l'ordre de 50°C (ou plus généralement entre 40°C et 60°C). Sa température de transition vitreuse Tg est préférentiellement inférieure à 100°C. Ses propriétés mécaniques sont caractérisées par exemple par un module d'Young de 1 GPa et par une élongation à la rupture de 100%. Il peut également être chargé en particules minérales ou bien renforcé de fibres minérales (tissu ou fibres de verre par exemple). On choisira de manière plus générale un matériau adhésif pouvant être appliqué par enduction à température ambiante (inférieure à 50°C). Il est adhésif par le fait qu'il adhère sur le support sur lequel il est enduit. Il peut également être adhésif par le fait que même après enduction et séchage, ses propriétés adhésives peuvent être réactivées par chauffage.

Selon une variante intéressante pour améliorer l'adhérence du substrat 7 sur les couches voisines du substrat dans la carte, le substrat 7 peut-être constitué d'un film adhésif réactivable à chaud (« hot-melt » selon la terminologie anglo-saxonne) de type co-polyamide, polyester, polyoléfine ou nitrile-phénolique, éventuellement renforcé de fibres minérales (tissu ou fibres de verre par exemple).

Le substrat 7 peut également être constitué plus classiquement d'un film souple de polyimide ou de verre-époxy d'environ 50 µm d'épaisseur, ou bien d'un film de PVC d'environ 150 µm d'épaisseur.

De nombreux substrats 7 sont réalisés sur une bande, par exemple, par un procédé continu de bobine à bobine. La bande est donc ensuite découpée pour individualiser les substrats 7. Les dimensions du substrat 7, dans le plan principal de celui-ci, sont telles qu'elles peuvent correspondre à celles de la carte finie, elles être plus petites que celles de la carte finie, mais en demeurant néanmoins supérieures à celles d'un module encartable de l'art antérieur.

Une puce électronique est fixée sur la deuxième face 11 puis encapsulée dans une résine, d'une manière connue par un procédé continu de bobine à bobine, avant individualisation des substrats 7. Sur les figures, la puce électronique est schématiquement représentée avec sa résine d'encapsulation 13 (« globe top » ou « dam&fill » selon la terminologie anglo-saxonne). La résine d'encapsulation 13 couvre la deuxième face 11 du substrat 7 sur une zone d'encapsulation 15.

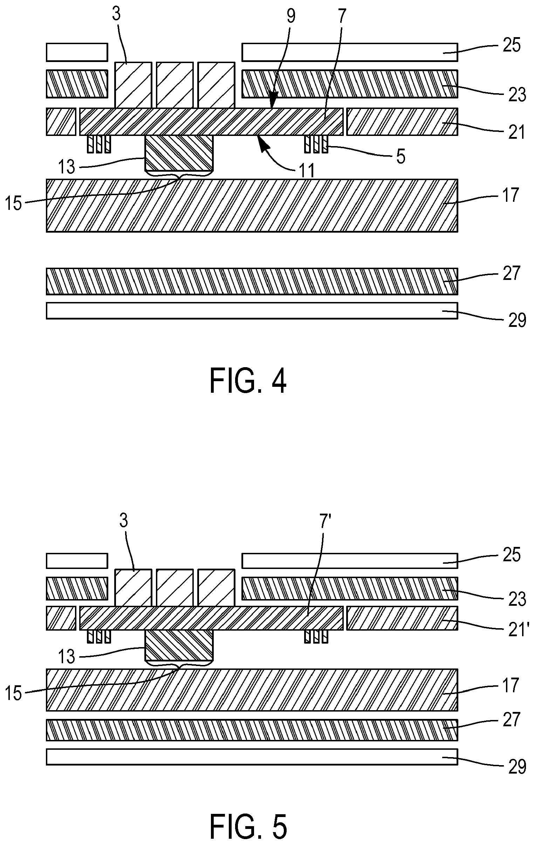

Chaque substrat 7 est ensuite reporté, avec une machine à bras-transfert (« pick and place machine» selon la terminologie anglo-saxonne) sur une couche d'absorption 17. La couche d'absorption 17 est donc placée sous la deuxième face 11, au moins sous l'antenne et autour de la zone d'encapsulation 15 et dans ce cas également sous la zone d'encapsulation 15 (voir figure 4). Cette couche d'absorption 17 est, par exemple, réalisée en PVC. Son épaisseur est, par exemple, comprise entre 300 et 400µm avant lamination. Plus précisément, son épaisseur peut être voisine de 360 µm avant lamination.

Comme représenté sur la figure 4, d'autres couches sont ensuite placées au-dessus, autour et au-dessous du substrat 7 placé sur la couche d'absorption 17.

Une couche de compensation 21 peut être disposée autour du substrat 7, sur la couche d'absorption 17. Cette couche de compensation 21 est, par exemple, réalisée en PVC. Son épaisseur est égale à celle du substrat, soit 60µm, à plus ou moins 10%, avant lamination. La totalité des épaisseurs de la couche d'absorption 17 et de la couche de compensation 21 est comprise entre 400 et 500 µm d'épaisseur avant lamination.

Une première couche d'impression 23 (ou couche imprimée) est disposée sur la couche de compensation 21. Cette première couche d'impression 23 est, par exemple, réalisée en PVC. Son épaisseur est par exemple voisine de 150µm. Cette première couche d'impression 23 comporte des motifs et des couleurs que l'on souhaite rendre visibles au recto de la carte 1. Elle recouvre une partie de la première face 9 du substrat 7. Autrement dit, comme on le voit sur la figure 4, le substrat 7 a des dimensions dans son plan principal supérieures à celles de la découpe réalisée dans toute l'épaisseur de cette couche d'impression 23 de manière à laisser apparaître les contacts 3.

Une couche supérieure 25 (« recto overlay » selon la terminologie anglo-saxonne) est disposée sur la première couche d'impression 23. Cette couche supérieure 25, située côté recto de la carte 1, est destinée à protéger sa surface supérieure, et en particulier la première couche d'impression 23. Elle est, par exemple, réalisée en PVC transparent. Son épaisseur est par exemple voisine de 60µm avant lamination. Une découpe est réalisée dans toute son épaisseur de manière à laisser apparaître les contacts 3. La couche supérieure 25 est disposée sur la première couche d'impression 23 de manière à ce que leurs découpes respectives coïncident.

Une deuxième couche d'impression (ou couche imprimée) 27 est disposée sous la couche d'absorption 17. Cette deuxième couche d'impression 27 est, par exemple, réalisée en PVC. Son épaisseur est par exemple voisine de 150µm. Cette deuxième couche d'impression 27 comporte des motifs et des couleurs que l'on souhaite rendre visibles au verso de la carte 1.

Une couche inférieure 29 (« verso overlay » selon la terminologie anglo-saxonne) est disposée sous la deuxième couche d'impression 27. Cette couche inférieure 29, située côté verso de la carte 1, est destinée à protéger sa surface inférieure, et en particulier la deuxième couche d'impression 27. Elle est, par exemple, réalisée en PVC transparent. Son épaisseur est par exemple voisine de 60µm avant lamination.

Selon une variante illustrée par la figure 5, la structure diffère de celle précédemment décrite essentiellement par le fait que :
- le substrat 7' est constitué d'un film de PVC d'environ 150 µm d'épaisseur, et
- la couche de compensation 21' a une épaisseur sensiblement égale à celle du substrat 7', soit environ 150 µm d'épaisseur.

Cette structure est ensuite placée entre deux plaques d'acier inoxydable parfaitement lisses afin de former un sandwich qui est ensuite introduit dans une presse de lamination (éventuellement à plateaux) pour y subir un cycle de lamination.

Avant lamination, l'ensemble des couches de cette variante a une épaisseur d'environ 940µm. Après lamination, cette structure a une épaisseur sensiblement égale à 800 µm environ. Cette épaisseur est donc aussi compatible avec la norme ISO 7810 qui préconise une épaisseur totale pour la carte 1 comprise entre 680 et 840 µm.

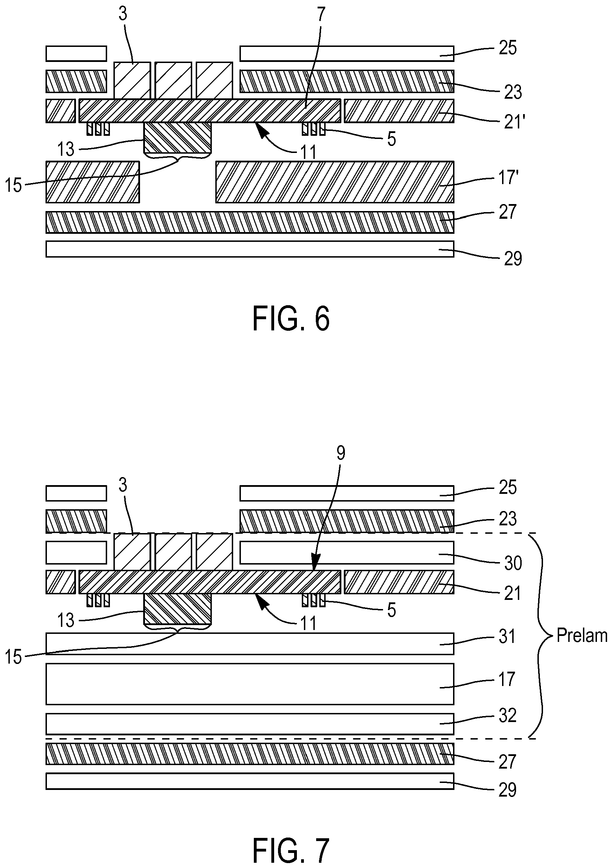

Selon une autre variante représentée sur la figure 6, chaque substrat 7 est reporté sur une couche de compensation 17' qui comprend une découpe servant de logement à la zone d'encapsulation 15. Dans ce cas, l'espace laissé vide entre les parois du logement et la zone d'encapsulation peut éventuellement être comblé par une résine souple et suffisamment fluide à la température de lamination. Cette variante permet en particulier d'insérer dans la carte 1, un substrat 7 avec une zone d'encapsulation 15 importante (par exemple 8 mm x 9 mm x 360 µm) tout en préservant l'esthétique du verso de la carte.

L'ensemble de la structure ainsi réalisée, c'est-à-dire l'ensemble des couches empilées, de la couche inférieure 29 à la couche supérieure 25, est placé entre deux plaques d'acier inoxydable parfaitement lisses pour former un sandwich qui est ensuite introduit dans une presse de lamination (éventuellement à plateaux).

La presse de lamination suit alors un temps de cycle en température et en pression composé d'un cycle chaud immédiatement suivi d'un cycle froid. La température de lamination à chaud est par exemple comprise entre 10 et 150°C, ou plus précisément encore, comprise entre 25 et 125° C, avec un plateau d'environ cinq minutes à 125° C, par exemple. La pression de lamination à chaud est par exemple comprise entre 0 et 100 N/cm², ou plus précisément encore, comprise entre 0 et 85 N/cm², avec un plateau à 85 N/cm² d'environ cinq minutes, synchrone avec celui de la température. La pression de lamination à froid est comprise entre 150 et 200 N/cm², ou plus précisément encore, maintenue autour de 180 N/cm² pendant environ 20 minutes, temps nécessaire pour que la température revienne à la température ambiante.

Avant lamination, l'ensemble des couches de la structure précédemment décrite a une épaisseur d'environ 840µm. Après lamination, cette structure a une épaisseur sensiblement égale à 780µm. Cette épaisseur est donc compatible avec la norme ISO 7810.

Par ailleurs, la différence de hauteur entre la face supérieure des contacts et le niveau supérieur de la couche supérieure 25 adjacente est inférieure à 10 µm environ après lamination (alors qu'elle était de 140µm avant lamination). Ce qui rend le procédé selon l'invention compatible avec la référence normative bancaire CQM (Card Quality Management version 2.3) de MasterCard qui spécifie cette différence de hauteur de ± 50 µm maximum.

De nombreuses autres variantes peuvent être envisagées, quant à la réalisation de la structure, par exemples :
- l'antenne 5 peut être au format de Classe 1 à 6 tel que décrit dans la norme ISO 14443-1, la nécessité de maintenir des performances RF compatibles avec les normes en vigueur (EMVCo par exemple pour les applications bancaires, c'est-à-dire Eurocard Mastercard Visa Compliance selon la terminologie anglo-saxonne ou bien encore ICAO pour les passeports et les cartes d'identité) pouvant alors nécessiter la connexion de composants passifs supplémentaires tels que des condensateurs silicium en parallèle de la capacité d'entrée de la puce Dual,
- la puce électronique peut être connectée aux contacts via des plots métallisés ou des puits de connexion traversant le substrat 7 ou 7',
- la puce électronique peut aussi être connectée à l'antenne 5 directement en face arrière ou en passant par des contacts situés en face avant, mais non connectés à la puce électronique,
- la lamination peut être réalisée en une ou plusieurs étapes, (voir par exemple la figure 7) ; on peut réaliser une première étape de lamination pendant laquelle un ensemble de couches d'absorption 17, 31 et 32 avec des épaisseurs respectives 60, 360 et 60 µm, de compensation 21, et d'une couche de collage 30 (composée d'un adhésif thermo-réactivable par exemple) de 60 µm d'épaisseur est laminé, puis une deuxième étape au cours de laquelle la couche supérieure 25, la première couche d'impression 23, la deuxième couche d'impression 27 et la couche inférieure 29 sont ajoutées et laminées avec la structure obtenue lors de la première étape de lamination,
- l'antenne 5 peut être réalisée en face avant ou en face arrière,
- la couche de compensation 17 peut être composée de plusieurs couches, et/ou
- les matériaux des différentes couches constituantes du corps de carte peuvent être en PVC/ABS, PET ou polycarbonate suivant la résistance mécanique et la durabilité souhaitée de la carte.

## Revendications

1. Procédé de fabrication d'une structure pour carte à puce, comprenant :
- la fourniture d'un substrat (7, 7') ayant une première et une deuxième faces principales (9, 11),
- la réalisation, sur la première face (9) du substrat (7, 7'), de contacts (3) pour une connexion électrique temporaire avec un dispositif de lecture à contacts de carte,
- la réalisation, sur la première (9) ou la deuxième (11) face du substrat (7, 7'), d'une antenne (5) pour un couplage électromagnétique avec un dispositif de lecture sans contact de cartes,
- la connexion électrique d'une puce électronique à au moins certains contacts (3) et à l'antenne (5),
- l'encapsulation de la puce sur une zone d'encapsulation (15),
- - la fourniture d'une couche (23, 25) au-dessus de la première face (9), avec une découpe réalisée dans toute l'épaisseur de cette couche (23, 25) de manière à laisser apparaître les contacts (3).

2. Procédé selon la revendication 1, comportant en outre la fourniture d'au moins une couche d'absorption (17, 17') placée sous la deuxième face (11) du substrat (7, 7'), au moins sous l'antenne et autour de la zone d'encapsulation (15).

3. Procédé selon la revendication 2, dans lequel la couche d'absorption (17, 17') s'étend sous la zone d'encapsulation (15).

4. Procédé selon l'une des revendications 2 et 3, dans lequel l'épaisseur de la couche d'absorption (17, 17') a une épaisseur comprise entre 300 et 400µm avant lamination.

5. Procédé selon l'une des revendications 2 à 4, comprenant en outre une première opération de lamination d'un ensemble de couches comprenant au moins le substrat et la couche d'absorption.

6. Procédé selon la revendication 5, dans lequel la première opération de lamination est réalisée à une température comprise entre 20 et 150°C.

7. Procédé selon l'une des revendications 2 à 6, comprenant la fourniture d'une couche d'impression (23) au-dessus de la première face (9), recouvrant une partie de la première face (9) du substrat (7), avec une découpe réalisée dans toute l'épaisseur de cette couche d'impression (23) de manière à laisser apparaître les contacts (3).

8. Procédé selon la revendication 7, comprenant la fourniture d'une couche supérieure (25) au-dessus de la couche d'impression (23) avec une découpe réalisée dans toute l'épaisseur de cette couche d'impression (23) de manière à laisser apparaître les contacts (3).

9. Procédé selon l'une des revendications précédentes, comprenant en outre la fourniture d'une couche d'impression (27) au-dessous de la deuxième face (11).

10. Procédé selon la revendication 9, comprenant en outre la fourniture d'une couche inférieure (29) au-dessous de la couche d'impression (27), située au-dessous de la deuxième face (11).

11. Procédé selon la revendication 10, comprenant en outre une deuxième opération de lamination d'un ensemble de couches comprenant au moins le substrat (7), la couche d'absorption (17, 17'), les couches d'impression (23, 27) et les couches inférieure (29) et supérieure (25).

12. Procédé selon la revendication 11, dans lequel la deuxième opération de lamination est réalisée à une température comprise entre 20 et 150°C.

13. Procédé selon l'une des revendications 1 à 10, dans lequel l'ensemble des couches (17 ou 17', 23, 25, 27, 29) est laminé au cours d'une unique opération de lamination.

14. Procédé selon l'une des revendications précédentes, comprenant en outre la fourniture d'une couche de compensation (21) autour du substrat, l'épaisseur de cette couche de compensation (21) étant égale à celle du substrat (7, 7'), à plus ou moins 10%.

15. Procédé selon l'une des revendications précédentes, dans lequel le substrat (7) est constitué d'une couche d'adhésif électriquement isolant.

16. Structure pour carte à puce comportant
- un substrat (7, 7') ayant une première (9) et une deuxième (11) faces principales,
- des contacts (3), sur la première face (9) du substrat (7, 7'), pour une connexion électrique temporaire avec un dispositif de lecture à contacts de carte,
- une antenne (5), sur la première (9) ou la deuxième (11) face du substrat (7, 7'), pour un couplage électromagnétique avec un dispositif de lecture sans contact de cartes,
- une puce électronique connectée à au moins certains contacts (3) et à l'antenne (5), et encapsulée sur une zone d'encapsulation (15),
**caractérisé par le fait que** la première face (9) du substrat (7, 7') est en partie recouverte d'une couche (23, 25) comportant une découpe laissant apparaître totalement les contacts (3).

17. Structure selon la revendication 16, comportant en outre au moins une couche d'absorption (17, 17') placée sous la deuxième face (11) du substrat (7, 7') au moins sous l'antenne et autour de la zone d'encapsulation (15).

18. Structure selon la revendication 17, dans laquelle la couche d'absorption (17, 17') est en PVC.

19. Structure selon la revendication 17 ou 18, comprenant en outre une couche de compensation (21) en PVC autour du substrat (7, 7'), sur la couche d'absorption (17, 17').

20. Structure selon l'une des revendications 16 à 18, comprenant en outre une couche supérieure (25) placée au-dessus de la première face (9) avec une découpe réalisée dans toute l'épaisseur de cette couche supérieure (25) de manière à laisser apparaître les contacts (3).

21. Structure selon la revendication 20, comprenant en outre une couche d'impression (23) entre la couche supérieure (25) et la première face (9) du substrat (7, 7'), recouvrant une partie de la première face (9) du substrat (7), avec une découpe réalisée dans toute l'épaisseur de cette couche d'impression (23) de manière à laisser apparaître les contacts (3).

22. Structure selon l'une des revendications 16 à 21, dans lequel le substrat (7) est constitué d'un matériau choisi dans la liste comprenant une couche d'adhésif électriquement isolant, un substrat polyimide, un substrat en verre-époxy et un substrat en PVC.

23. Structure selon l'une des revendications 16 à 22, comportant un composant passif connecté à l'antenne (5).

24. Structure selon l'une des revendications 16 à 23, dans laquelle l'antenne (5) est au format de l'une des classes 1 à 6 de la norme ISO14443-1.

## Patentansprüche

1. Verfahren zur Herstellung einer Struktur für Chipkarten, umfassend:
- Bereitstellen eines Substrats (7, 7') mit einer ersten und einer zweiten Hauptseite (9, 11),
- Bereitstellen, auf der ersten Seite (9) des Substrats (7, 7'), von Kontakten (3) für eine vorübergehende elektrische Verbindung mit einem Kontakt-Kartenlesegerät,
- Bereitstellen, auf der ersten Seite (9) oder der zweiten Seite (11) des Substrats (7, 7'), einer Antenne (5) zur elektromagnetischen Kopplung mit einem Kontaktlos-Kartenlesegerät,
- elektrische Verbindung eines elektronischen Chips zumindest mit bestimmten Kontakten (3) und mit der Antenne (5),
- Einkapselung des Chips in einem Verkapselungsbereich (15),
- Bereitstellen einer Schicht (23, 25) über der ersten Seite (9), wobei ein Ausschnitt durch die gesamte Dicke dieser Schicht (23, 25) gemacht wird, derart, dass die Kontakte (3) freigelegt werden.

2. Verfahren nach Anspruch 1, ferner beinhaltend das Bereitstellen mindestens einer Absorptionsschicht (17, 17'), die unter der zweiten Seite (11) des Substrats (7, 7'), zumindest unter der Antenne und um die Einkapselungszone (15) herum, angeordnet ist.

3. Verfahren nach Anspruch 2, wobei sich die Absorptionsschicht (17, 17') unter die Einkapselungszone (15) erstreckt.

4. Verfahren nach einem der Ansprüche 2 und 3, wobei die Absorptionsschicht (17, 17') vor dem Laminieren eine Dicke zwischen 300 und 400 µm aufweist.

5. Verfahren nach einem der Ansprüche 2 bis 4, ferner umfassend einen ersten Vorgang des Laminierens einer Schichtenanordnung, die mindestens das Substrat und die Absorptionsschicht umfasst.

6. Verfahren nach Anspruch 5, wobei der erste Vorgang des Laminierens bei einer Temperatur zwischen 20 und 150 °C durchgeführt wird.

7. Verfahren nach einem der Ansprüche 2 bis 6, umfassend das Bereitstellen einer Druckschicht (23) über der ersten Seite (9), die einen Teil der ersten Seite (9) des Substrats (7) bedeckt, mit einem Ausschnitt, der durch die gesamte Dicke dieser Druckschicht (23) ausgeführt ist, derart, dass die Kontakte (3) freigelegt werden.

8. Verfahren nach Anspruch 7, umfassend das Bereitstellen einer obersten Schicht (25) über der Druckschicht (23) mit einem Ausschnitt, der durch die gesamte Dicke dieser Druckschicht (23) ausgeführt ist, derart, dass die Kontakte (3) freigelegt werden.

9. Verfahren nach einem der vorhergehenden Ansprüche, ferner umfassend das Bereitstellen einer Druckschicht (27) unter der zweiten Seite (11).

10. Verfahren nach Anspruch 9, ferner umfassend das Bereitstellen einer untersten Schicht (29) unter der Druckschicht (27), angeordnet unter der zweiten Seite (11).

11. Verfahren nach Anspruch 10, ferner umfassend einen zweiten Vorgang des Laminierens einer Schichtenanordnung, die mindestens das Substrat (7), die Absorptionsschicht (17, 17'), die Druckschichten (23, 27) und die unterste Schicht (29) und oberste Schicht (25) umfasst.

12. Verfahren nach Anspruch 11, wobei der zweite Vorgang des Laminierens bei einer Temperatur zwischen 20 und 150 °C durchgeführt wird.

13. Verfahren nach einem der Ansprüche 1 bis 10, wobei die Schichtenanordnung (17 oder 17', 23, 25, 27, 29) in einem einzigen Lamniniervorgang laminiert wird.

14. Verfahren nach einem der vorhergehenden Ansprüche, ferner umfassend das Bereitstellen einer Kompensationsschicht (21) um das Substrat herum, wobei die Dicke dieser Kompensationsschicht (21) gleich der des Substrats (7, 7') ist, und zwar im Bereich von plus oder minus 10%.

15. Verfahren nach einem der vorhergehenden Ansprüche, wobei das Substrat (7) aus einer Schicht elektrisch isolierenden Klebstoffs besteht.

16. Struktur für Chipkarten, umfassend:
- ein Substrat (7, 7') mit einer ersten Hauptseite (9) und einer zweiten Hauptseite (11),
- Kontakte (3), auf der ersten Seite (9) des Substrats (7, 7'), für eine vorübergehende elektrische Verbindung mit einem Kontakt-Kartenlesegerät,
- eine Antenne (5) auf der ersten Seite (9) oder der zweiten Seite (11) des Substrats (7, 7') zur elektromagnetischen Kopplung mit einem Kontaktlos-Kartenlesegerät,
- ein elektronischer Chip, der zumindest mit bestimmten Kontakten (3) und der Antenne (5) verbunden und in einem Verkapselungsbereich (15) verkapselt ist, **dadurch gekennzeichnet, dass** die erste Seite (9) des Substrats (7, 7') teilweise mit einer Schicht (23, 25) bedeckt ist, die einen Ausschnitt beinhaltet, der die Kontakte (3) vollständig freilegen lässt.

17. Struktur nach Anspruch 16, ferner beinhaltend mindestens eine Absorptionsschicht (17, 17'), die unter der zweiten Seite (11) des Substrats (7, 7'), zumindest unter der Antenne und um die Einkapselungszone (15) herum, angeordnet ist.

18. Struktur nach Anspruch 17, wobei die Absorptionsschicht (17, 17') aus PVC besteht.

19. Struktur nach Anspruch 17 oder 18, ferner umfassend eine Ausgleichsschicht (21) aus PVC um das Substrat (7, 7') herum auf der Absorptionsschicht (17, 17').

20. Struktur nach einem der Ansprüche 16 bis 18, ferner umfassend eine oberste Schicht (25), die über der ersten Seite (9) angeordnet ist, mit einem Ausschnitt, der durch die gesamte Dicke dieser obersten Schicht (25) ausgeführt ist, derart, dass die Kontakte (3) freigelegt werden.

21. Struktur nach Anspruch 20, ferner umfassend eine Druckschicht (23) zwischen der obersten Schicht (25) und der ersten Seite (9) des Substrats (7, 7'), die einen Teil der ersten Seite (9) des Substrats (7) bedeckt, mit einem Ausschnitt, der durch die gesamte Dicke dieser Druckschicht (23) ausgeführt ist, derart, dass die Kontakte (3) freigelegt werden.

22. Struktur nach einem der Ansprüche 16 bis 21, wobei das Substrat (7) aus einem Material ausgewählt aus der Liste umfassend eine Schicht elektrisch isolierenden Klebstoffs, ein Polyimidsubstrat, ein Glas-Epoxysubstrat und ein PVC-Substrat besteht.

23. Struktur nach einem der Ansprüche 16 bis 22, beinhaltend ein passives Bauteil, das mit der Antenne (5) verbunden ist.

24. Struktur nach einem der Ansprüche 16 bis 23, wobei die Antenne (5) ein Format nach einer der Klassen 1 bis 6 der Norm ISO14443-1 aufweist.

## Claims

1. Method for manufacturing a chip-card structure, comprising:
- providing a substrate (7, 7') having first and second main faces (9, 11),
- producing, on the first face (9) of the substrate (7, 7'), contacts (3) for a temporary electrical connection to a contact card-reading device,
- producing, on the first face (9) or second face (11) of the substrate (7, 7'), an antenna (5) for electromagnetic coupling to a contactless card-reading device,
- electrically connecting an electronic chip to at least certain contacts (3) and to the antenna (5),
- encapsulating the chip in an encapsulating zone (15),
- providing a layer (23, 25) above the first face (9), with a cutout produced right through the thickness of this layer (23, 25) so as to let the contacts (3) appear.

2. Method according to Claim 1, furthermore comprising providing at least one absorbing layer (17, 17') placed under the second face (11) of the substrate (7, 7'), at least under the antenna and around the encapsulating zone (15).

3. Method according to Claim 2, wherein the absorbing layer (17, 17') extends under the encapsulating zone (15).

4. Method according to one of Claims 2 and 3, wherein the thickness of the absorbing layer (17, 17') has a thickness comprised between 300 and 400 µm before lamination.

5. Method according to one of Claims 2 to 4, furthermore comprising a first operation of laminating a set of layers comprising at least the substrate and the absorbing layer.

6. Method according to Claim 5, wherein the first laminating operation is carried out at a temperature comprised between 20 and 150°C.

7. Method according to one of Claims 2 to 6, comprising providing a printing layer (23) above the first face (9), covering one portion of the first face (9) of the substrate (7), with a cutout produced right through the thickness of this printing layer (23) so as to let the contacts (3) appear.

8. Method according to Claim 7, comprising providing a top layer (25) above the printing layer (23) with a cutout produced right through the thickness of this printing layer (23) so as to let the contacts (3) appear.

9. Method according to one of the preceding claims, furthermore comprising providing a printing layer (27) below the second face (11).

10. Method according to Claim 9, furthermore comprising providing a bottom layer (29) below the printing layer (27), located below the second face (11).

11. Method according to Claim 10, furthermore comprising a second operation of laminating a set of layers comprising at least the substrate (7), the absorbing layer (17, 17'), the printing layers (23, 27) and the top and bottom layers (25, 29).

12. Method according to Claim 11, wherein the second laminating operation is carried out at a temperature comprised between 20 and 150°C.

13. Method according to one of Claims 1 to 10, wherein all of the layers (17 or 17', 23, 25, 27, 29) are laminated in a single laminating operation.

14. Method according to one of the preceding claims, furthermore comprising providing a compensating layer (21) around the substrate, the thickness of this compensating layer (21) being equal to that of the substrate (7, 7'), to within plus or minus 10%.

15. Method according to one of the preceding claims, wherein the substrate (7) consists of an electrically insulating adhesive layer.

16. Chip-card structure comprising
- a substrate (7, 7') having a first main face (9) and a second main face (11),
- contacts (3), on the first face (9) of the substrate (7, 7'), for a temporary electrical connection to a contact card-reading device,
- an antenna (5), on the first face (9) or second face (11) of the substrate (7, 7'), for electromagnetic coupling to a contactless card-reading device,
- an electronic chip connected to at least certain contacts (3) and to the antenna (5), and encapsulated in an encapsulating zone (15),
- **characterized in that** the first face (9) of the substrate (7, 7') is partially covered with a layer (23, 25) comprising a cutout that lets the contacts (3) entirely appear.

17. Structure according to Claim 16, furthermore comprising at least one absorbing layer (17, 17') placed under the second face (11) of the substrate (7, 7') at least under the antenna and around the encapsulating zone (15).

18. Structure according to Claim 17, wherein the absorbing layer (17, 17') is made of PVC.

19. Structure according to Claim 17 or 18, furthermore comprising a compensating layer (21) made of PVC around the substrate (7, 7'), on the absorbing layer (17, 17').

20. Structure according to one of Claims 16 to 18, furthermore comprising a top layer (25) placed above the first face (9) with a cutout produced right through the thickness of this top layer (25) so as to let the contacts (3) appear.

21. Structure according to Claim 20, furthermore comprising a printing layer (23) between the top layer (25) and the first face (9) of the substrate (7, 7'), covering one portion of the first face (9) of the substrate (7), with a cutout produced right through the thickness of this printing layer (23) so as to let the contacts (3) appear.

22. Structure according to one of Claims 16 to 21, wherein the substrate (7) is made of a material chosen from the list comprising an electrically insulating adhesive layer, a polyimide substrate, a substrate made of epoxy glass and a substrate made of PVC.

23. Structure according to one of Claims 16 to 22, comprising a passive component connected to the antenna (5).

24. Structure according to one of Claims 16 to 23, wherein the antenna (5) is in the format of one of classes 1 to 6 of standard IS014443-1.
